# EUROPEAN PATENT APPLICATION

(11) **EP 3 517 292 A1**
(43) Date of publication of application: **31.07.2019**
(21) Application number: 17853068.9
(22) Date of filing: 20.09.2017
(51) Int. Cl.: B32B 27/00, C09J 183/04, H01L 21/301, H01L 23/29, H01L 23/31

(54) **LAMINATE, MANUFACTURING METHOD THEREOF, AND MANUFACTURING METHOD OF ELECTRONIC COMPONENT**

(30) Priority: 26.09.2016 JP 2016186543
(71) Applicant: Dow Corning Toray Co., Ltd., Tokyo 100-0004 (JP)
(72) Inventor: FUKUI Hiroshi, Ichihara-shi Chiba 299-0108 (JP); TOYAMA Kyoko, Ichihara-shi Chiba 299-0108 (JP); DOGEN Ryota, Ichihara-shi Chiba 299-0108 (JP); USHIO Yoshito, Ichihara-shi Chiba 299-0108 (JP)
(74) Representative: Murgitroyd & Company
(86) International application number: PCT/JP2017/033870
(87) International publication number: WO 2018/056298

(57) **Abstract**

Problem: It is an object of the present invention to provide a laminate having, on a substrate, a gel layer which is excellent in heat resistance and the like, has low elastic modulus, low stress and excellent in stress buffering properties and flexibility, is soft and excellent in holding property of electronic components and the like before curing, and after curing, the gel layer is changed to a hard cured layer which is higher in shape retention and excellent in mold releasability than before curing, and a method for manufacturing the same. Further, it is an object of the present invention to provide a method for manufacturing an electronic component in which the use of the laminate makes it difficult to cause problems such as deposits of silicone gel or a cured product thereof to a substrate or an electronic component, and makes it difficult to cause problems of defects or defective products of the electronic component.

Solution: A laminate including a curing reactive silicone gel layer on at least one type of substrate and its use.

## Description

### TECHNICAL FIELD

The present invention relates to a laminate including a substrate and a curing reactive silicone gel layer which changes in physical properties from a gel layer which is soft and excellent in holding property of electronic components and the like to a hard cured product layer, and a manufacturing method thereof. The present invention also provides a method of manufacturing an electronic component using the same.

### BACKGROUND ART

Silicone gels can be obtained by curing reacting organopolysiloxanes having reactive functional groups so as to have low crosslink density, and are excellent in heat resistance, weather resistance, oil resistance, cold resistance, electrical insulation, and the like, and exhibit low elastic modulus, low stress, and excellent stress buffering properties because of being a gel form, unlike ordinary elastomer products, and are widely used for protecting damping materials for optical applications, in-vehicle electronic components, and consumer electronic components (for example, Patent Documents 1 to 7). In particular, since the silicone gel is soft and easily deformed and can be arranged in accordance with the unevenness of the surface of the substrate, unlike a silicone elastomer or a hard cured product, the silicone gel exhibits good followingness even with respect to a substrate which is not flat, and has an advantage that a gap or a separation does not easily occur.

However, since such a silicone gel is a "gel-form", it is weak against deformation due to external stress such as vibration or internal stress due to expansion or contraction caused by temperature change, and in the case where the gel is destroyed or it is necessary to separate or cut (dice operation or the like) from an electronic member or the like requiring protection, adhesion or stress buffering, sticky deposits may remain on the object, or the gel may generate cohesive failure on the substrate, so that the gel cannot be easily removed from the substrate, the electronic component, or the like. Such gel deposits are not preferable because they may cause defects in electronic components and the like, and also cause troubles and defective products during mounting of semiconductors and the like. On the other hand, if the crosslink density of the organopolysiloxane is increased and completely cured, it is impossible to realize the properties of low elastic modulus, low stress, and excellent stress buffering properties which are the superiority of the silicone gel, and the followingness of the gel layer with respect to the uneven substrate is deteriorated, which may cause a gap and a separation from the substrate. For this reason, conventional cured products such as silicone gel materials and silicone elastomers have not been able to solve the above-mentioned problems at all.

On the other hand, in the field of adhesive films and semiconductor sealants, there has been proposed a curable composition in which a curing reaction proceeds in multiple stages, assuming different curing reaction conditions. For example, Patent Document 8 discloses a thermosetting composition which exhibits adhesiveness required in a dicing process by curing in a first stage and strong adhesiveness by curing in a second stage, by a two-stage curing reaction, and is suitably used in a dicing die bond adhesive sheet. Further, in Patent Document 9, the present applicants propose a curable silicone composition which is excellent in initial curability and maintains a high physical strength even when exposed to a high temperature of 250°C. or higher.

However, in the heretofore known curable compositions assuming multistage curing, there is no description or suggestion of the technical benefits of forming a silicone gel or changing from a soft gel to a hard completely cured product.

### Prior Art Documents

### Patent Documents

Patent Document 1: JP 59-204259 A
Patent Document 2: JP 61-048945 A
Patent Document 3: JP 62-104145 A
Patent Document 4: JP 2003-213132 A (JP 3865638 B)
Patent Document 5: JP 2012-017458 A (JP 5594232 B)
Patent Document 6: WO 2015/155950 (JP 5794229 B)
Patent Document 7: JP 2011-153249 A
Patent Document 8: JP 2007-191629 A (JP 4628270 B)
Patent Document 9: JP 2016-124967 A

### SUMMARY OF THE INVENTION

### Problems to be Solved by the Invention

The present invention has been made to solve the above-mentioned problems, and an object of the present invention is to provide a laminate having, on a substrate, a gel layer which is excellent in heat resistance, has low elastic modulus, low stress, excellent in stress buffering properties and flexibility, soft and excellent in retention property of electronic components, etc. before curing, and after curing, the gel layer is changed to a hard cured layer having higher shape retention and excellent in mold releasability than before curing, and a method of manufacturing the same. Further, it is an object of the present invention to provide a method for manufacturing an electronic component in which the use of the laminate makes it difficult to cause problems such as deposits of silicone gel or a cured product thereof to a substrate or an electronic component, and makes it difficult to cause problems of defects or defective products of the electronic component.

### Means for Solving the Problems

As a result of intensive studies, the present inventors have found that the above-mentioned problems can be solved by a laminate having a curing reactive silicone gel layer on at least one type of substrate, and have arrived at the present invention.

Furthermore, the present inventors have found that the above-mentioned problem can be solved by a manufacturing method of a laminate including (A-1) a step of applying a curable silicone composition capable of forming a silicone gel layer by a primarily curing reaction on at least one type of substrate, and (A-2) a step of forming a curing reactive silicone gel layer by primarily curing the curable silicone composition on the substrate in a gel form, and have arrived at the present invention.

In addition, the present inventors have found that the above-mentioned problems can be solved by a manufacturing method of an electronic component including (I) a step of arranging at least one or more electronic components on the silicone gel layer of the laminate, and (II) a step of curing a part or whole of the silicone gel layer, and have arrived at the present invention.

That is, the object of the present invention is achieved by the following laminate.
[1] A laminate including a curing reactive silicone gel layer on at least one type of substrate.
[2] The laminate according to [1], wherein a storage modulus (G'_{cured}) of a cured product of the silicone gel layer obtained by a curing reaction is increased by 100% or more as compared with a storage modulus (G'_{gel}) of the silicone gel layer before curing.
[3] The laminate according to [1] or [2], wherein a loss factor, tan δ of the silicone gel layer is in the range of 0.01 to 1.00 at 23°C. to 100°C.
[4] The laminate according to any one of [1] to [3], wherein the silicone gel layer is curing reactive to heating, irradiation with high energy rays, or a combination thereof.
[5] The laminate according to any one of [1] to [4], wherein the silicone gel layer contains one or more curing agents selected from a hydrosilylation reaction catalyst, an organic peroxide, and a photopolymerization initiator.
[5-1] The laminate according to [5], wherein the curing agent is encapsulated.
[6] The laminate according to any one of [1] to [5], wherein the silicone gel layer is obtained by curing a curable silicone composition containing at least a resinous or branched chain curing reactive organopolysiloxane into a gel form.
[7] The laminate according to [6], wherein the silicone gel layer is formed by curing the curable silicone composition in a gel form in a temperature range of room temperature to 100°C.
[8] The laminate according to any one of [1] to [7], wherein an average thickness of the silicone gel layer is in the range of 10 to 500 µm.
[9] The laminate according to [1], wherein the substrate is a release layer-provided sheet-shaped substrate (substrate R), and the silicone gel layer is formed on the release layer.
   Further, the object of the present invention is achieved by the following laminate.
[10] The laminate according to any one of [1] to [8], wherein at least one or more electronic components are arranged on the silicone gel layer.
[11] A laminate obtained by curing the silicone gel layer on the laminate of
[10] to thereby provide a structure of a substrate, a cured layer, and at least one or more electronic components arranged on the cured layer.
   Similarly, the object of the present invention is achieved by the following laminate.
[12] A method of manufacturing the laminate according to any one of [1] to [8], including:
   (A-1) a step of applying a curable silicone composition capable of forming a silicone gel layer by a primarily curing reaction on at least one type of substrate, and
   (A-2) a step of forming a curing reactive silicone gel layer by primarily curing the curable silicone composition on the substrate in a gel form.
[13] A method of manufacturing the laminate according to any one of [1] to [8], including:
   (B-1) a step of applying a curable silicone composition capable of forming a silicone gel layer by a primarily curing reaction on a release layer of a release layer-provided sheet-shaped substrate (substrate R),
   (B-2) a step of forming a curing reactive silicone gel layer by primarily curing the curable silicone composition on the release layer in a gel form, and a step of arranging the silicone gel layer of the laminate obtained in step (B-2) on at least one type of substrate different from the substrate R, and removing only the substrate R.

   Further, the object of the present invention is achieved by the following method of manufacturing an electronic component.
[14] A method of manufacturing an electronic component, including:
   (I) a step of arranging at least one or more electronic components on the silicone gel layer of the laminate according to any one of [1] to [8], and
   (II) a step of curing a part or whole of the silicone gel layer.
[15] The method of manufacturing an electronic component according to [14], further including (III) a step of separating the electronic components from a cured product obtained by curing a part or whole of the silicone gel layer by step (II).

### Effects of the Invention

According to the laminate of the present invention, there is provided, on a substrate, a silicone gel layer which is excellent in heat resistance and the like, has low elastic modulus, low stress, and excellent in stress buffering properties and flexibility, and which is soft and excellent in holding property of electronic components and the like before curing, and after curing, the silicone gel layer is changed to a hard cured layer which is higher in shape retention and excellent in mold releasability than before curing. Further, by using the laminate of the present invention, it is possible to provide a method for manufacturing an electronic component which hardly causes problems such as deposits of silicone gel or a cured product thereof to a substrate or an electronic component, and hardly causes problems of defects or defective products of the electronic component.

### Mode for Carrying Out the Invention

A laminate of the present invention is a laminate including a curing reactive silicone gel layer on at least one type of substrate. Details thereof will be described below.

### Curing Reactive Silicone Gel Layer

The laminate is characterized by including a curing reactive silicone gel layer. The silicone gel layer exhibits a non-fluid gel form, and causes a curing reaction in response to heating, irradiation with high energy rays, or the like, and changes to a hard cured layer having higher shape retention and superior mold releasability than before curing reaction. Although the shape of the silicone gel layer is not particularly limited as long as it is layered, it is preferable that the silicone gel layer be a substantially flat silicone gel layer when it is used for the manufacturing application of an electronic component to be described later. The thickness of the silicone gel layer is not particularly limited, but an average thickness may be in the range of 10 to 500 µm, in the range of 25 to 300 µm, or in the range of 30 to 200 µm. If the average thickness is less than 10 µm, gaps derived from unevenness on a substrate are difficult to fill, and if the average thickness is more than 500 µm, it may be uneconomical to use a silicone gel layer for arrangement at the time of temporary retention/processing of an electronic component, in particular, in an electronic component manufacturing application.

The silicone gel layer is an organopolysiloxane crosslinked product having a relatively low crosslink density, and from the viewpoints of flexibility, low elastic modulus, low stress and stress buffering properties required for the gel, a loss factor, tan δ (measured from a viscoelasticity measuring device at a frequency of 0.1 Hz) of the silicone gel layer is preferably in the range of 0.01 to 1.00 at 23°C. to 100°C., and more preferably in the range of 0.03 to 0.95 and 0.10 to 0.90 at 23°C. In the silicone gel layer of the present invention, the curing reaction hardly proceeds rapidly at 50°C. or lower, preferably 80°C. or lower, more preferably 100°C. or lower, and the loss factor, tan δ of the silicone gel layer satisfies the above range in the above temperature range. The loss factor, tan δ of the silicone gel layer can be easily measured by isolating the silicone gel layer (sheet) by means such as separating the silicone gel layer from the substrate or primarily curing a curable organopolysiloxane composition as the raw material on a peelable substrate.

The silicone gel layer is characterized in that it is curing reactive and changes from the above-mentioned gel form properties and physical properties to a hard cured layer having higher shape retention and excellent mold releasability. More specifically, the storage elastic modulus G'_{cured} of the cured product of the silicone gel layer obtained by the curing reaction is preferably at least 100% larger than the storage elastic modulus G'_{gel} of the silicone gel layer before curing, and more preferably 150% or more, 200% or more, or 300% or more larger than the storage elastic modulus G'_{gel} of the silicone gel layer before curing. That is, the larger the G'_{cured}/G'_{gel} is, the more the soft and flexible gel form material is changed to a hard cured product having higher shape retention.

The curing reaction mechanism of the silicone gel layer is not particularly limited, but may include, for example, a hydrosilylation reaction curing type by an alkenyl group and a silicon atom-bonded hydrogen atom; a dehydration condensation reaction curing type or a dealcoholization condensation reaction curing type by a silanol group and/or a silicon atom-bonded alkoxy group; a peroxide curing reaction type using an organic peroxide; and a radical reaction curing type by high energy ray irradiation to a mercapto group or the like, and it is desirable to use a hydrosilylation reaction curing type, a peroxide curing reaction type, a radical reaction curing type or the combination thereof since the whole is cured relatively quickly and the reaction can be easily controlled. These curing reactions proceed with heating, irradiation with high energy radiation, or a combination thereof.

When the silicone gel layer is cured by heating, it includes at least a step of curing the whole by a curing reaction by heating at a temperature exceeding 100°C., preferably at a temperature exceeding 120°C., more preferably at 150°C. or higher, and most preferably at 170°C. or higher. Heating at 150°C. or higher is particularly suitably employed when the curing reaction mechanism of the silicone gel is particularly a peroxide curing reaction type mechanism or a curing reaction mechanism including an encapsulated hydrosilylation reaction catalyst. In practice, a range of from 120°C. to 200°C. or from 150 to 180°C. is suitably chosen. Although it is also possible to heat-cure at a relatively low temperature of 50°C. to 100°C., it is preferable that the silicone gel layer according to the laminate of the present invention maintains a gel form at a low temperature, and therefore, in particular, it is preferable that the curing reaction does not substantially proceed, i.e., the gel form is maintained, at a temperature of 50°C. or lower.

Examples of high energy rays (also referred to as active energy rays) include ultraviolet rays, electron beams, radiation, and the like, but ultraviolet rays are preferable from the viewpoint of practicality. As the ultraviolet ray generating source, a high-pressure mercury lamp, a medium-pressure mercury lamp, a Xe-Hg lamp, a deep UV lamp, or the like is suitable, and in particular, ultraviolet irradiating with a wavelength of 280 to 400 nm, preferably with a wavelength of 350 to 400 nm is preferable. The irradiation amount in this case is preferably 100 to 10,000 mJ/cm². When the silicone gel is cured by high energy rays, a selective curing reaction is possible regardless of the above-mentioned temperature conditions.

Practically, a preferable curing operation, a preferable curing reaction mechanism and conditions for curing the curing reactive silicone gel layer of the present invention are as follows. The heating time or the irradiation amount of the ultraviolet rays can be appropriately selected in accordance with the thickness of the silicone gel layer, the intended physical properties after curing, and the like.
(i) Heating operation of silicone gel layer at 120 to 200°C.: hydrosilylation reaction curing type, peroxide curing reaction type, or a combination thereof.
(ii) Ultraviolet irradiation operation on silicone gel layer: radical reaction curing type by high energy ray irradiation, hydrosilylation reaction curing type using photoactive platinum complex curing catalyst, or combination thereof.
(iii) Combinations of curing operations, curing mechanisms and conditions of the above (i) and (ii), particularly combinations of simultaneous or staggered curing operations, are included.

The curing reactive silicone gel layer is obtained as a gel form cured product of a curable silicone composition (primarily curing reaction). Here, unreacted curing reactive functional groups or unreacted organic peroxides are present in the silicone crosslinked product constituting the silicone gel layer, and further curing reaction (secondarily curing reaction) proceeds by the above-mentioned curing operation to form a hard cured product having a higher crosslink density. When the curable silicone composition is used as a starting material, a curing reactive silicone gel layer, which is a constituent element of the present invention, is obtained by a primarily curing reaction, and further, the silicone gel is changed to a harder cured layer by a secondarily curing reaction. In the curing reaction including the peroxide curing reaction, the silicone gel layer can be cured even if the functional group is not curing reactive in another curing reaction mechanism such as an alkyl group.

The primarily curing reaction mechanism for forming a silicone gel layer from a curable silicone composition is not particularly limited, and includes, for example, a hydrosilylation reaction curing type by an alkenyl group and a silicon atom-bonded hydrogen atom; a dehydration condensation reaction curing type or a dealcoholization condensation reaction curing type by a silanol group and/or a silicon atom-bonded alkoxy group; a peroxide curing reaction type by the use of an organic peroxide; a radical reaction curing type by high energy ray irradiation to a mercapto group or the like; and a hydrosilylation reaction curing type by high energy ray irradiation using a photoactive platinum complex curing catalyst or the like. The (secondarily) curing reaction mechanism of the silicone gel and the mechanism of the primarily curing reaction when forming the silicone gel layer may be the same or different. For example, after a silicone gel layer is formed on a substrate by a dehydration condensation reaction, a dealcoholization condensation reaction, or high energy ray irradiation without performing a heating operation, the silicone gel layer may be heated at a high temperature to cure the silicone gel layer. When the same curing mechanism is selected as the primarily curing reaction for obtaining the silicone gel from the curable silicone composition and the secondarily curing reaction for further curing the silicone gel, it is necessary that the unreacted curing reactive groups and the unreacted curing agents remain in the silicone gel obtained by primarily curing the curable silicone composition except for the peroxide curing reaction type.

As described above, since the silicone gel layer is curing reactive, it is preferable to contain one or more curing agents selected from a hydrosilylation reaction catalyst, an organic peroxide, and a photopolymerization initiator. These curing agents may be encapsulated, and in particular encapsulated curing agents, specifically hydrosilylation reaction catalysts, may be suitably used in view of the storage stability of the silicone gel layer and the control of the curing reaction. Furthermore, a hydrosilylation reaction catalyst such as a photoactive platinum complex curing catalyst that promotes a hydrosilylation reaction by high energy ray irradiation such as ultraviolet rays may be used.

These curing agents can be left in an unreacted state in the silicone gel by designing the amount of the curing agents such that when the curing reactive silicone gel is formed by primarily curing the curable silicone composition, the curing agents remain in the silicone gel even after primarily curing, or by selecting conditions so that the primarily curing reaction and the secondarily curing reaction after the formation of the silicone gel are different curing reactions, and adding the curing agents corresponding to each curing reaction, or the like.

As the hydrosilylation reaction catalyst, platinum-based catalysts, rhodium-based catalysts, and palladium-based catalysts are exemplified, and platinum-based catalysts are preferable because the curing of the present composition can be remarkably accelerated. Examples of the platinum-based catalyst include platinum fine powder, chloroplatinic acid, an alcohol solution of chloroplatinic acid, a platinum-alkenyl siloxane complex, a platinum-olefin complex, a platinum-carbonyl complex, and a catalyst in which these platinum-based catalysts are dispersed or encapsulated with a thermoplastic resin such as silicone resin, polycarbonate resin, acrylic resin or the like, with a platinum-alkenyl siloxane complex particularly preferable. Examples of this alkenyl siloxane include: 1,3-divinyl-1,1,3,3-tetramethyldisiloxane; 1,3,5,7-tetramethyl-1,3,5,7-tetravinylcyclotetrasiloxane; an alkenyl siloxane obtained by substituting part of methyl groups of these alkenyl siloxanes with an ethyl group, a phenyl group, etc.; and an alkenyl siloxane obtained by substituting part of vinyl groups of these alkenyl siloxanes with an allyl group, a hexenyl group, etc. In particular, 1,3-divinyl-1,1,3,3-tetramethyldisiloxane is preferable because the platinum-alkenyl siloxane complex has good stability. As the catalyst for promoting the hydrosilylation reaction, a non-platinum based metal catalyst such as iron, ruthenium, iron/cobalt, or the like may be used.

In addition, in the curing reactive silicone gel layer of the present invention, a particulate platinum-containing hydrosilylation reaction catalyst dispersed or encapsulated with a thermoplastic resin may be used. The use of such encapsulated curing agents provides the advantages of improved storage stability of the curing reactive silicone gel layer and control over the temperature of the curing reaction, in addition to the advantages of improved conventional handling workability and improved pot life of the composition. That is, at the time of forming the silicone gel by the primarily curing reaction, the encapsulated curing agent can be left in an unreacted and inert state in the silicone gel by selecting a temperature condition under which the thermoplastic resin (wall material of the capsule containing the curing agent) such as wax which forms the capsule does not melt. This can be expected to improve the storage stability of the silicone gel layer containing the curing agent. Furthermore, by selecting a high temperature condition exceeding the melting temperature of the thermoplastic resin which forms the capsule in the curing reaction (secondarily curing reaction) of the silicone gel, the reaction activity of the curing agent in the capsule can be selectively expressed only at a specific high temperature condition. This makes it possible to easily control the curing reaction of the silicone gel. The thermoplastic resin (wall material of the capsule containing the curing agent) such as wax or the like can be appropriately selected in accordance with the temperature condition for forming the silicone gel and the temperature condition for curing the curing reactive silicone gel, and the curing agent is not limited to the platinum-containing hydrosilylation reaction catalyst.

In the present invention, besides heating, a hydrosilylation reaction catalyst such as a photoactive platinum complex curing catalyst that promotes a hydrosilylation reaction by high energy ray irradiation such as ultraviolet rays may be used. Such a hydrosilylation reaction catalyst is preferably exemplified by a platinum complex having a β-diketone platinum complex or a cyclic diene compound as its ligand, and platinum complexes selected from the group consisting of trimethyl(acetylacetonato)platinum complex, trimethyl(2,4-pentanedionate)platinum complex, trimethyl(3,5-heptanedionate)platinum complex, trimethyl(methylacetoacetate)platinum complex, bis(2,4-pentanedionato)platinum complex, bis(2,4-hexanedionato)platinum complex, bis(2,4-heptanedionato)platinum complex, bis(3,5-heptanedionato)platinum complex, bis(1-phenyl-1,3-butanedionato)platinum complex, bis(1,3-diphenyl-1,3-propanedionato)platinum complex, (1,5-cyclooctadienyl)dimethyl platinum complex, (1,5-cyclooctadienyl)diphenyl platinum complex, (1,5-cyclooctadienyl)dipropyl platinum complex, (2,5-norboradiene)dimethyl platinum complex, (2,5-norboradiene)diphenyl platinum complex, (cyclopentadienyl)dimethyl platinum complex, (methylcyclopentadienyl)diethyl platinum complex, (trimethylsilylcyclopentadienyl)diphenyl platinum complex, (methylcycloocta-1,5-dienyl)diethyl platinum complex, (cyclopentadienyl)trimethyl platinum complex, (cyclopentadienyl)ethyldimethyl platinum complex, (cyclopentadienyl)acetyldimethyl platinum complex, (methylcyclopentadienyl)trimethyl platinum complex, (methylcyclopentadienyl)trihexyl platinum complex, (trimethylsilylcyclopentadienyl)trimethyl platinum complex, (trimethylsilylcyclopentadienyl)trihexyl platinum complex, (dimetylphenylsilylcyclopentadienyl)triphenyl platinum complex, and (cyclopentadienyl)dimethyltrimethylsilylmethyl platinum complex are specifically exemplified.

In the case of using a curing agent that promotes a hydrosilylation reaction by the above-mentioned high energy ray irradiation, the silicone gel can be formed by the primarily curing reaction or the curing reaction of the silicone gel by the secondarily curing can proceed without performing a heating operation using the curable silicone composition as a raw material.

The content of the hydrosilylation reaction catalyst is preferably an amount in which the metal atoms are in the range of 0.01 to 500 ppm, an amount in the range of 0.01 to 100 ppm, or an amount in the range of 0.01 to 50 ppm in terms of mass unit, when the entire silicone gel is 100 parts by mass.

Examples of organic peroxides include alkyl peroxides, diacyl peroxides, ester peroxides, and carbonate peroxides. In particular, when curing of the curing reactive silicone gel layer is allowed to proceed selectively at a high temperature, a 10-hour half-life temperature of the organic peroxide is preferably 70°C. or higher, and may be 90°C. or higher. In the case of selecting high energy ray irradiation in the primarily curing reaction for forming the silicone gel, it is preferable to select an organic peroxide which is not deactivated by the primarily curing.

Examples of alkyl peroxides include dicumyl peroxide, di-tert-butyl peroxide, di-tert-butylcumyl peroxide, 2,5-dimethyl-2,5-di(tert-butylperoxy)hexane, 2,5-dimethyl-2,5-di(tert-butylperoxy)hexyne-3, tert-butylcumyl, 1,3-bis(tert-butylperoxyisopropyl)benzene, and 3,6,9-triethyl-3,6,9-trimethyl-1,4,7-triperoxonan.

Examples of diacyl peroxides include benzoyl peroxide such as p-methylbenzonyl peroxide, lauroyl peroxide and decanoyl peroxide.

Examples of ester peroxides include 1,1,3,3-tetramethylbutylperoxyneodecanoate, α-cumylperoxyneodecanoate, tert-butylperoxyneodecanoate, tert-butylperoxyneoheptanoate, tert-butylperoxypivalate, tert-hexylperoxypivalate, 1,1,3,3-tetramethylbutylperoxy-2-ethylhexanoate, tert-amylperoxyl-2-ethylhexanoate, tert-butylperoxy-2-ethylhexanoate, tert-butylperoxyisobutyrate, di-tert-butylperoxyhexahydroterephthalate, tert-amylperoxy-3,5,5-trimethylhexanoate, tert-butylperoxy-3,5,5-trimethylhexanoate, tert-butylperoxyacetate, tert-butylperoxybenzoate, and di-butylperoxytrimethyladipate.

Examples of carbonate peroxides include di-3-methoxybutyl peroxydicarbonate, di(2-ethylhexyl)peroxydicarbonate, diisopropyl peroxycarbonate, tert-butyl peroxyisopropylcarbonate, di(4-tert-butylcyclohexyl)peroxydicarbonate, dicetyl peroxydicarbonate, and dimyristyl peroxydicarbonate.

The organic peroxides preferably have a 10-hour half-life temperature of 70°C. or higher, and may be 90°C. or higher, or may be 95°C. or higher. Examples of such organic peroxides include p-methylbenzonyl peroxide, dicumyl peroxide, di-tert-butyl peroxide, di-tert-hexyl peroxide, tert-butylcumyl peroxide, 2,5-dimethyl-2,5-di(tert-butylperoxy)hexane, 1,3-bis(tert-butylperoxyisopropyl)benzene, di-(2-tert-butylperoxyisopropyl)benzene, and 3,6,9-triethyl-3,6,9-trimethyl-1,4,7-triperoxonan.

The content of the organic peroxide is not limited, but it is preferably in the range of 0.05 to 10 parts by mass or in the range of 0.10 to 5.0 parts by mass when the entire silicone gel is 100 parts by mass.

Photopolymerization initiators are components that generate radicals by high energy ray irradiation such as ultraviolet rays and electron beams, and include for example, acetophenone and its derivatives such as acetophenone, dichloroacetophenone, trichloroacetophenone, tert-butyltrichloroacetophenone, 2,2-diethoxyacetophenone, and p-dimethylaminoacetophenone; benzoin and its derivatives such as benzoin, benzoin methyl ether, benzoin ethyl ether, benzoin butyl ether, and benzoin n-butyl ether; benzophenone and its derivatives such as benzophenone, 2-chlorobenzophenone, p,p'-dichlorobenzophenone, and p,p'-bisdiethylaminobenzophenone; p-dimethylaminopropiophenone, Michler's ketone, benzyl, benzyl dimethyl ketal, tetramethyl thiuram monosulfide, thioxanthone, 2-chlorothioxanthone, 2-methylthioxanthone, azoisobutyronitrile, benzoin peroxide, di-tert-butylperoxide, 1-hydroxycyclohexyl phenyl ketone, 2-hydroxy-2-methyl-1-phenyl-propan-1-one, 1- (4-isopropylphenyl)-2-hydroxy-2-methylpropane-1-one, methyl benzoyl formate, diphenyl sulfide, anthracene, 1-chloroanthraquinone, diphenyl disulfide, diacetyl, hexachlorobutadiene, pentachlorobutadiene, octachlorobutadiene, and 1-chloromethyl naphthalene are exemplified, and preferably are acetophenone, benzoin, benzophenone, and derivatives thereof.

The blending amount of the photopolymerization initiator is not particularly limited, but is preferably in the range of 0.1 to 10 parts by mass with respect to 100 parts by mass of the entire silicone gel.

When the silicone gel contains a photopolymerization initiator as a curing agent, the silicone gel may contain a photosensitizer such as n-butylamine, di-n-butylamine, tri-n-butylphosphine, allylthiourea, s-benzyl isothiuronium-p-toluene sulfinate, triethylamine, diethylaminoethyl methacrylate, or the like as other optional components.

As long as the silicone gel layer according to the present invention is a silicone gel layer having the above-mentioned curing reactivity, it is not particularly limited in the composition of the curable silicone composition as a raw material and the primarily curing condition, but it is preferable that the storage stability at room temperature to 100°C. after the formation of the silicone gel layer is good and the gel form is maintained, and that the secondarily curing reaction is selectively progressed by irradiation with high energy rays or heating at 100°C. or higher, preferably at 120°C. or higher, more preferably at 150°C. or higher, and that the control thereof is easy. For this reason, in particular, in the case of designing such that the curing reaction of the silicone gel layer proceeds selectively at a high temperature, it is preferable to cure the curable silicone composition as a raw material thereof into a gel form at a temperature range of room temperature to 100°C., that is, at a relatively low temperature. In particular, when a curing mechanism including a hydrosilylation curing reaction or a curing reaction by an organic peroxide is selected as a secondarily curing reaction after forming a silicone gel, since these curing reactions do not sufficiently proceed at a low temperature of 100°C. or lower, there is an advantage that a curing reactive functional group or a curing agent remains unreacted in the silicone gel formed by the primarily curing reaction in the above-mentioned temperature range, and a curing reactive silicone gel layer that can be selectively cured at a high temperature can be easily obtained.

Such a curing reactive silicone gel layer is preferably obtained by curing a curable silicone composition containing at least a resinous or branched chain organopolysiloxane in a gel form, particularly when a hydrosilylation reaction is selected as a primarily curing reaction, and in particular, it is preferably obtained by curing a curable silicone composition containing a resinous organopolysiloxane having at least two alkenyl groups in one molecule in a gel form. The resinous or branched chain curing reactive organopolysiloxane is an organopolysiloxane that contains a tetrafunctional siloxy unit represented by SiO_{4/2} or a trifunctional siloxy unit represented by RSiO_{3/2} (wherein R is a monovalent organic group or a hydroxyl group), and has a curing reactive functional group capable of forming a silicone gel by a primarily curing reaction.

### Substrate

The substrate on which the silicone gel layer is laminated may have unevenness, and it is particularly preferable that the unevenness is filled or followed without a gap by the silicone gel layer to form a flat silicone gel layer. Since the curing reactive silicone gel layer of the present invention is flexible and excellent in deformability and followingness, it is difficult to generate a gap even with respect to a substrate having unevenness, and it is advantageous in that problems such as a separation and a deformation of the silicone gel surface do not occur.

The substrate used in the present invention is not particularly limited, and a desired substrate may be appropriately selected. Examples of the substrate include adherends or substrates made of glass, ceramics, mortar, concrete, wood, aluminum, copper, brass, zinc, silver, stainless steel, iron, zinc coated steel, tin plate, nickel plated surfaces, epoxy resins, phenol resins, and the like. Further, an adherend or a substrate made of a thermoplastic resin such as a polycarbonate resin, a polyester resin, an ABS resin, a nylon resin, a polyvinyl chloride resin, a polyphenylene sulfide resin, a polyphenylene ether resin, or a polybutylene terephthalate resin is exemplified. They may be in the form of rigid plates or flexible sheets. Alternatively, the substrate may be a film-shaped or sheet-shaped substrate having extensibility such as that used for a substrate such as a dicing tape.

The substrate used in the present invention may be subjected to a surface treatment such as a primer treatment, a corona treatment, an etching treatment, a plasma treatment or the like for the purpose of improving adhesion and adhesiveness with the curing reactive silicone gel layer. As a result, even after the curing reactive silicone gel layer is cured to form a cured product layer having excellent shape retention and mold releasability, and even after low adhesion, the adhesion between the cured product layer and the substrate is kept sufficiently high, and separation of the electronic components and the like arranged on the cured product layer can be made easier.

On the other hand, in the case where the laminate of the present invention is used for manufacturing an electronic component, examples of the substrate include a pedestal on which the electronic component is at least temporarily arranged in the manufacturing process, a semiconductor wafer for the laminate application, a ceramic element including a ceramic capacitor, and a substrate which can be used as a substrate for the electronic circuit application. In particular, it is preferable that the substrate be usable as a pedestal, a circuit substrate, a semiconductor substrate, or a semiconductor wafer for processing electronic components.

Although the material of these substrates is not particularly limited, examples of members suitably used as a circuit board or the like include organic resins such as glass epoxy resin, bakelite resin, phenol resin, and the like; ceramics such as alumina; metals such as copper and aluminum; and materials such as silicon wafers for semiconductor use. Further, when the substrate is used as a circuit board, a conductive wire made of a material such as copper or silver-palladium may be printed on the surface of the substrate. The curing reactive silicone gel of the present invention is advantageous in that the unevenness of the surface of these circuit boards can be filled or followed without a gap to form a flat silicone gel surface.

On the other hand, the laminate of the present invention may be a laminate in which a curing reactive silicone gel layer is formed on a release layer of a release layer-provided sheet-shaped substrate (substrate R). In this case, the silicone gel layer can be easily peeled off from the substrate R, and only the silicone gel layer can be transferred onto another substrate, preferably the above-mentioned circuit board or semiconductor substrate. That is, the laminate of the present invention includes not only a laminate in which a silicone gel layer is formed on a non-peelable and uneven substrate such as a circuit board in advance, but also a concept of a peelable laminate for handling the silicone gel layer itself as a member of such a laminate.

The release layer-provided sheet-shaped substrate (substrate R) is substantially flat, and a substrate having an appropriate width and thickness depending on the application of a tape, a film, or the like can be used without particular limitation, but specifically, a composite sheet-shaped substrate formed by laminating paper, a synthetic resin film, cloth, a synthetic fiber, a metal foil (aluminum foil, copper foil, or the like), glass fibers, and a plurality of these sheet-shaped substrates is exemplified. In particular, a synthetic resin film is preferable, and a synthetic resin film such as polyester, polytetrafluoroethylene, polyimide, polyphenylene sulfide, polyamide, polycarbonate, polystyrene, polypropylene, polyethylene, polyvinyl chloride, polyvinylidene chloride, polycarbonate, polyethylene terephthalate, nylon, or the like can be exemplified. The thickness is not particularly limited, but is usually about 5 to 300 µm.

As the release agent used for forming the release layer, for example, an olefin resin, an isoprene resin, a rubber elastomer such as a butadiene resin, a long chain alkyl resin, an alkyd resin, a fluorine resin, a silicone resin, or the like is used. In particular, the use of a release agent composed of a silicone resin is preferable, and the use of a release agent containing a fluorine-modified silicone resin containing a fluoroalkyl group is particularly preferable.

When the curing reactive silicone gel layer according to the present invention is formed on the above-mentioned release layer-provided sheet-shaped substrate (substrate R), when the curing reactive silicone gel layer is transferred to a substrate different from the substrate R, surface treatment such as a primer treatment, a corona treatment, an etching treatment, a plasma treatment, or the like may be performed on the silicone gel surface facing the substrate for the purpose of improving the adhesiveness and adhesive property of the curing reactive silicone gel. This improves the adhesion of the curing reactive silicone gel layer separated from the substrate R to other substrates.

### Laminate Including Electronic Components

The laminate of the present invention may be further characterized in that at least one or more electronic components are arranged on the silicone gel layer. Though the type of the electronic component is not particularly limited as long as it can be arranged on the silicone gel layer, there are exemplified a semiconductor wafer, a ceramic element (including a ceramic capacitor), a semiconductor chip, and a light-emitting semiconductor chip which are elements of a semiconductor chip, and two or more electronic components which are the same or different may be arranged on the silicone gel layer. Since the curing reactive silicone gel layer in the laminate of the present invention is a gel form and can select curing conditions, even when it is handled in a temperature region at a high temperature to some extent, the curing reaction hardly progresses, and is moderately flexible and excellent in followingness and deformability, it is possible to form a stable and flat arrangement surface of an electronic component. Further, even when the electronic component arranged on the gel layer is stably held at a fixed position on a flat gel surface to alleviate vibration and shock in the manufacturing process of the electronic component, and processing such as processing of forming various patterns and dicing is performed on the electronic component, there is an advantage that processing defects of the electronic component due to surface unevenness of the substrate, positional deviation of the electronic component, and vibration displacement (damping) do not easily occur. The holding of the electronic component or the like on the gel is derived from the viscoelasticity of the gel, and includes both holding by the weak adhesive force of the gel itself and carrying of the electronic component by deformation of the gel.

These electronic components may be arranged on the silicone gel layer at least partially in a state of having a configuration of an electronic circuit, an electrode pattern, an insulating film, or the like, or after being arranged on the silicone gel layer, may form an electronic circuit, an electrode pattern, an insulating film, or the like. When the electrode pattern or the like is formed, conventionally known means can be used without any particular limitation, and the electrode pattern or the like may be formed by a vacuum evaporation method, a sputtering method, an electroplating method, a chemical plating method, an etching method, a printing method, or a lift-off method. When the laminate of the present invention is used for manufacturing an electronic component, it is particularly preferable to form an electronic circuit, an electrode pattern, an insulating film, or the like of the electronic component on the silicone gel layer, and the laminate may optionally be diced. As described above, the use of the silicone gel layer suppresses processing defects of these electronic components.

The laminate of the present invention is a laminate in which at least one or more electronic components described above are arranged on a silicone gel layer, and which is formed by curing the silicone gel layer, and may have a structure composed of a substrate, a cured layer, and at least one or more electronic components arranged on the cured layer.

Since the silicone gel layer is cured to form a cured layer having excellent shape retention, hardness, and surface releasability, only the electronic component can be easily separated from the cured layer in the laminate including the electronic component and the cured layer, and there is an advantage that foreign matter such as a residue (adhesive deposit) derived from the silicone gel hardly adheres to the electronic component and a defective product does not easily occur.

### Manufacturing Method of Laminate

The laminate of the present invention is obtained by forming a silicone gel layer on a substrate, and can be manufactured by applying a curable silicone composition, which is a raw material composition of the silicone gel layer, on a target substrate and curing it in a gel form as desired. Similarly, when the above-mentioned release layer-provided sheet-shaped substrate (substrate R) is used, it can be manufactured by separating the silicone gel layer from the release layer and transferring the silicone gel layer onto another substrate.

That is, the laminate of the present invention can be obtained by a production method including a step (A-1) of applying a curable silicone composition capable of forming a silicone gel layer by primarily curing reaction on at least one kind of substrate, and a step (A-2) of forming a curable reactive silicone gel layer by primarily curing of the curable silicone composition on the substrate in a gel form.

Here, the substrate may be the above-mentioned release layer-provided sheet-shaped substrate (substrate R), and in this case, the resulting laminate is a releasable laminate for transferring the curing reactive silicone gel layer as a member onto another substrate.

Similarly, the laminate of the present invention can be obtained by a production method including a step (B-1) of applying a curable silicone composition capable of forming a silicone gel layer by primarily curing reaction on a release layer of a release layer-provided sheet-shaped substrate (substrate R), a step (B-2) of forming a curable reactive silicone gel layer by primarily curing of the curable silicone composition in a gel form on the release layer, and a step of arranging the silicone gel layer of the laminate obtained in the above step on at least one type of substrate different from the above substrate R and removing only the substrate R.

In this case, a surface treatment such as a primer treatment, a corona treatment, an etching treatment, a plasma treatment, or the like may be performed on a surface of the silicone gel layer of the laminate, which is different from the above-mentioned substrate R and which faces at least one type of substrate, on a surface of the silicone gel facing the substrate for the purpose of improving its adhesiveness and adhesion property, and it is preferable. This improvement in adhesiveness has the advantage that the substrate R can be easily separated.

When a curing reactive silicone gel layer is formed on the above-mentioned release layer-provided sheet-shaped substrate (substrate R), and is later separated from the release layer and handled as a sheet-shaped member, a silicone gel layer having a uniform surface may be formed by the following method.

### Method of Preparation Using Curing Between Separators Having Release Layer

Although it is preferable that the curing reactive silicone gel layer is substantially flat, when the curable silicone composition serving as a raw material thereof is applied onto a substrate having a release layer by a usual method, particularly when the thickness of the cured silicone gel layer is 50 µm or more, the applied surface may form a concave non-uniform surface, and the surface of the obtained silicone gel layer may become non-uniform. However, by applying a substrate having a release layer to the curable silicone composition and the silicone gel layer, sandwiching an uncured application surface between the sheet-shaped substrates each provided with a release layer (the above-mentioned substrate R; separator), and forming a physically uniform flattening layer, a flattened curing reactive silicone gel layer can be obtained. In forming the flattening layer, it is preferable that a laminate obtained by applying an uncured curable silicone composition between separators having a release layer is rolled by a known rolling method such as roll sheeting.

### Curable Silicone Composition

The curing reactive silicone gel layer which constitutes the laminate of the present invention is obtained by primarily curing a curable silicone composition into a gel form. As described above, the primarily curing reaction for forming the silicone gel layer may be a curing reaction mechanism different from the secondarily curing reaction of the silicone gel itself, or may be the same curing reaction mechanism. On the other hand, from the viewpoint of the stability of the silicone gel layer at 100°C. or lower, it is preferable to cure the curable silicone composition into a gel form in a temperature range of room temperature to 100°C.

Such a curable silicone composition preferably contains (A) an organopolysiloxane having at least two curing reactive groups in one molecule and (C) a curing agent, optionally (B) an organohydrogenpolysiloxane. In particular, when the primarily curing reaction or the secondarily curing reaction is a reaction mechanism of a hydrosilylation reaction curing type, the component (A) is preferably a mixture of (A-1) a linear organopolysiloxane having at least two curing reactive groups in one molecule and (A-2) a resinous or branched chain organopolysiloxane having at least two curing reactive groups in one molecule, and the curable silicone composition further contains (B) an organohydrogenpolysiloxane and (C) a curing agent. Here, the curing reactive group is not particularly limited, but a photopolymerizable functional group such as an alkenyl group or a mercapto group is exemplified.

The curable silicone composition forms a curing reactive silicone gel by a curing reaction such as a hydrosilylation reaction curing type by an alkenyl group and a silicon atom-bonded hydrogen atom; a dehydration condensation reaction curing type or a dealcoholization condensation reaction curing type by a silanol group and/or a silicon atom-bonded alkoxy group such as an alkoxysilyl group; a peroxide curing reaction type by the use of an organic peroxide; a radical reaction curing type by high energy ray irradiation to a mercapto group or the like; or a hydrosilylation reaction curing type by high energy ray irradiation using a photoactive platinum complex curing catalyst or the like, depending on a primarily curing mechanism. When the peroxide curing reaction is selected, a functional group such as an alkyl group, which is not curing reactive in other curing reaction mechanisms can be cured into a gel form in some cases.

When the primarily curing reaction is a hydrosilylation curing reaction, the curing reactive group includes at least an alkenyl group, in particular an alkenyl group having 2 to 10 carbon atoms. The alkenyl group having 2 to 10 carbon atoms includes a vinyl group, an allyl group, a butenyl group, and a hexenyl group. Preferably, the alkenyl group having 2 to 10 carbon atoms is a vinyl group.

Similarly, when the primarily curing reaction is a hydrosilylation curing reaction, the curable silicone composition preferably contains an organohydrogenpolysiloxane having two or more Si-H bonds in a molecule as a crosslinking agent. In this case, the alkenyl group of the organopolysiloxane can hydrosilylate with the silicon atom-bonded hydrogen atom of the organohydrogenpolysiloxane to form a curing reactive silicone gel layer. In this case, it is necessary to use the same hydrosilylation reaction catalyst as described above.

As described above, the primarily curing reaction of the present invention is preferably performed at 100°C. or lower, preferably at 80°C. or lower. When the primarily curing reaction is a hydrosilylation curing reaction, high energy ray irradiation using a photoactive platinum complex curing catalyst or the like may be performed, and the curing reaction may not proceed sufficiently at a low temperature to form a gel form cured product having a low crosslink density.

When the curing reaction is a dehydration condensation reaction curing type or a dealcoholization condensation reaction curing type, the above-mentioned curing reactive group is a silanol group (Si-OH) or a silicon atom-bonded alkoxy group, and an alkoxy group having 1 to 10 carbon atoms such as a methoxy group, an ethoxy group, or a propoxy group is suitably exemplified as the alkoxy group. The alkoxy group may be attached to the side chain or end of the organopolysiloxane, may be in the form of an alkylalkoxysilyl group or an alkoxysilyl group containing group attached to a silicon atom via other functional groups, and is preferred. Further, the organopolysiloxane having the curing reactive group may have a functional group of a dehydration condensation reaction curing type or a dealcoholization condensation reaction curing type, and a curing reactive group by another curing mechanism in the same molecule. For example, in addition to a silicon atom-bonded alkoxy group or a silanol group, a hydrosilylation reactive functional group or a photopolymerizable functional group may be present in the same molecule. It should be noted that one of the preferred forms of the present invention is to use a curable silicone composition of a dehydrated condensation reaction curing type or a dealcoholization condensation reaction curing type, containing an organic peroxide to form a gel form curing layer by a condensation reaction, and then to secondarily cure the gel layer with the organic peroxide by heating or the like, since the functional group having the curing reactivity is not required in the peroxide curing reaction.

In particular, when a silicon atom-bonded alkoxy group is selected as the curing reactive group, an alkoxysilyl group containing group represented by the general formula of a silicon atom bond: 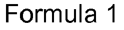 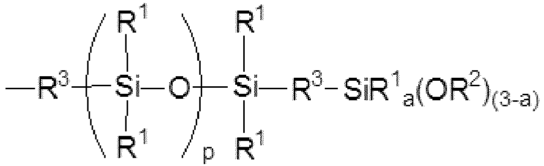 is suitably exemplified.

In the above formula, R¹ is a monovalent hydrocarbon group having no aliphatic unsaturated bond, which is the same or different, and is preferably a methyl group or a phenyl group. R² is an alkyl group, and is preferably a methyl group, an ethyl group, or a propyl group because it constitutes an alkoxy group having dealcoholization condensation reactivity. R³ is an alkylene group bonded to a silicon atom, and is preferably an alkylene group having 2 to 8 carbon atoms. a is an integer of 0 to 2, and p is an integer of 1 to 50. From the viewpoint of dealcoholization condensation reactivity, most preferably, a is 0, and a trialkoxysilyl group containing group is preferable. In addition to the above alkoxysilyl group containing group, a functional group having hydrosilylation reactivity or a functional group having photopolymerization reactivity may be contained in the same molecule.

When the primarily curing reaction is a dehydration condensation reaction curing type or a dealcoholization condensation reaction curing type, the above-mentioned crosslinking agent is unnecessary, but an organohydrogenpolysiloxane may be included in order to proceed the secondarily curing reaction.

In the case of a dehydration condensation reaction curing type or a dealcoholization condensation reaction curing type, it is preferable to use a condensation reaction catalyst as a curing agent. The condensation reaction catalyst is not particularly limited, and examples thereof include organic tin compounds such as dibutyltin dilaurate, dibutyltin diacetate, tin octenate, dibutyltin dioctate, and tin laurate; organic titanium compounds such as tetrabutyl titanate, tetrapropyl titanate, and dibutoxy bis(ethyl acetoacetate); acidic compounds such as hydrochloric acid, sulfuric acid, and dodecylbenzene sulfonic acid; alkaline compounds such as ammonia and sodium hydroxide; amine-based compounds such as 1,8-diazabicyclo[5.4.0]undecene (DBU), and 1,4-diazabicyclo[2.2.2]octane (DABCO).

When the primarily curing reaction is a peroxide curing reaction, the above-mentioned curing reactive group may be a radical reactive functional group by peroxide, and a peroxide curing reactive functional group such as an alkyl group, an alkenyl group, an acrylic group, or a hydroxyl group can be used without limitation. However, as described above, since the peroxide curing reaction generally proceeds at a high temperature of 150°C. or higher, in a laminate of the present invention, it is preferable that the peroxide curing reaction is selected as the curing of the silicone gel layer, that is, the secondarily curing reaction. This is because, under a temperature condition in which the peroxide curing reaction proceeds, including a functional group having a high energy ray curing reactivity, the curing reaction by most of the curing reactivity functional groups is completely terminated and a gel-form cured product layer cannot be obtained in some cases. Since some organic peroxides may be deactivated by high energy ray irradiation, it is preferable to appropriately select the type and amount of the organic peroxides in accordance with the primarily curing reaction.

When the primarily curing reaction is of the radical reaction curing type by high energy ray irradiation, the curing reactive functional group is a photopolymerizable functional group, and is a mercaptoalkyl group such as a 3-mercaptopropyl group and an alkenyl group similar to those described above, or an acrylamide group such as N-methylacrylamidopropyl. Here, the conditions under which the high energy ray irradiation is irradiated are not particularly limited, and for example, a method in which the composition is irradiated at room temperature or while being cooled or heated to 50 to 150°C. in air, in an inert gas such as nitrogen gas, argon gas, helium gas, or the like, or in a vacuum is given, and it is particularly preferable to irradiate the composition at room temperature in air. In addition, since some of the photopolymerizable functional groups may cause poor curing by being in contact with air, the surface of the curable silicone composition may optionally be coated with a synthetic resin film or the like which transmits high energy rays at the time of high energy ray irradiation. Here, when the curable silicone composition is primarily cured into a gel form at room temperature by using ultraviolet rays having a wavelength of 280 to 450 nm, preferably 350 to 400 nm, there is an advantage that the secondarily curing reaction can be easily controlled by selecting the thermal curing reaction as the secondarily curing reaction, since the curing system accompanied by other heating, in particular, the curing reactive group and the curing agent of the hydrosilylation curing reaction or the peroxide curing reaction can be left unreacted in the curing reactive silicone gel layer.

The curing reactive silicone gel layer is formed from a curable silicone composition containing (A) an organopolysiloxane having a curing reactive group as described above, (B) an organohydrogenpolysiloxane depending on a curing reaction, and (C) a curing agent, and in the case where the hydrosilylation curing reaction is included in either the primarily curing reaction for forming the silicone gel layer of the present invention or the secondarily curing reaction for forming the cured layer from the silicone gel layer, it is preferable that the curable silicone composition contains (A-1) a linear organopolysiloxane having at least two curing reactive groups in one molecule and (A-2) a resinous or branched chain organopolysiloxane having at least two curing reactive groups in one molecule.

Component (A-1) is a linear organopolysiloxane having at least two curing reactive groups in one molecule. The property of component (A-1) at room temperature may be an oil or a raw rubber, and the viscosity of component (A-1) is preferably 50 mPa·s or more, especially 100 mPa·s or more, at 25°C. In particular, when the curable silicone composition is in a solvent form, it is preferable that component (A-1) has a viscosity of 100,000 mPa·s or more at 25°C. or is a raw rubber-form component having a plasticity degree. However, even lower viscosity (A-1) components can be used.

Component (A-2) is a resinous or branched chain organopolysiloxane having at least two curing reactive groups in one molecule, and in particular the use of a resinous curing reactive organopolysiloxane (organopolysiloxane resin) having at least two curing reactive groups in one molecule is particularly preferred. Examples of component (A-2) may include, for example, a resin composed of R₂SiO_{2/2} units (D units) and SiO_{3/2} units (T units) (wherein each R is independently a monovalent organic group or a hydroxyl group), and having at least two curing reactive groups, hydroxyl groups or hydrolyzable groups in the molecule, a resin composed of the T units alone and having at least two curing reactive groups, hydroxyl groups or hydrolyzable groups in the molecule, and a resin composed of R3SiO1/2 units (M units) and SiO4/2 units (Q units), and having at least two curing reactive groups, hydroxyl groups or hydrolyzable groups in the molecule, and the like. In particular, it is preferable to use a resin (also referred to as MQ resin) composed of R3SiO1/2 units (M units) and SiO4/2 units (Q units), and having at least two curing reactive groups, hydroxyl groups or hydrolyzable groups in the molecule. The hydroxyl groups or hydrolyzable groups are directly bonded to silicon of the T units or Q units in the resin, and are groups derived from silane as a raw material or generated as a result of hydrolysis of silane.

The curing reactive functional groups of component (A-1) and component (A-2) may be functional groups relating to the same curing reaction mechanism or may be substances relating to different curing reaction mechanisms. The curing reactive functional groups of component (A-1) and component (A-2) may be functional groups relating to two or more types of curing reaction mechanisms different in the same molecule. For example, component (A-1) or component (A-2) may be an organopolysiloxane having a photopolymerizable functional group and/or a hydrosilylation reactive functional group and a condensation reactive functional group in the same molecule, the structure of which is linear in component (A-1) and resinous or branched chain in component (A-2). When a hydrosilylation reaction is used in either the primarily curing reaction or the secondarily curing reaction, it is preferable to include component (A-2), but as described above, component (A-2) may be a resinous or branched chain organopolysiloxane having a functional group relating to two or more different curing reaction mechanisms, and is preferable.

Component (B) is an organohydrogenpolysiloxane and is an optional crosslinking component or molecular chain extending component. In particular, when the curing reactive functional group is an alkenyl group and the curing agent contains a hydrosilylation reaction catalyst, it is preferable to contain component (B). Preferably, component (B) is an organohydrogenpolysiloxane having two or more Si-H bonds in the molecule.

Component (C) is a curing agent, which is one or more curing agents selected from the hydrosilylation reaction catalysts, the organic peroxides, and the photopolymerization initiators described above.

To the extent that the technical effect of the laminate of the present invention is not impaired, the curable silicone composition may include components other than those described above. For example, the composition may include: a curing retardant; an adhesion imparting agent; a non-reactive organopolysiloxane such as polydimethylsiloxane or polydimethyldiphenylsiloxane; an antioxidant such as a phenol type, a quinone type, an amine type, a phosphorus type, a phosphite type, a sulfur type, or a thioether type; a light stabilizer such as a triazole type or a benzophenone type; a flame retardant such as a phosphate ester type, a halogen type, a phosphorus type, or an antimony type; one or more antistatic agents consisting of a cationic surfactant, an anionic surfactant, or a nonionic surfactant, and the like; a dye; a pigment; a reinforcing filler; a thermoconductive filler; a dielectric filler; an electrically conductive filer; a releasable component; and the like.

In particular, the reinforcing filler is a component which imparts mechanical strength to the silicone gel and improves thixotropy, and may be capable of suppressing the silicone gel layer from softening and lowering or deforming the shape retention due to heating or the like when the silicone gel layer is subjected to the secondarily curing reaction. This is effective in efficiently suppressing a situation in which the electronic component or the like arranged on the silicone gel layer is buried in the silicone gel layer or in which it is difficult to separate the electronic component or the like from the cured layer. In addition, the blending of the reinforcing filler may further improve the mechanical strength, the shape retention, and the surface releasability of the cured product after the secondarily curing reaction. Examples of such reinforcing fillers include inorganic fillers such as fumed silica fine powder, precipitated silica fine powder, calcined silica fine powder, fumed titanium dioxide fine powder, quartz fine powder, calcium carbonate fine powder, diatomaceous earth fine powder, aluminum oxide fine powder, aluminum hydroxide fine powder, zinc oxide fine powder, zinc carbonate fine powder. The reinforcing fillers may contain inorganic fillers obtained by surface treating these inorganic fillers with a treating agent such as organoalkoxysilanes such as methyltrimethoxysilane, organohalosilanes such as trimethylchlorosilane, organosilanes such as hexamethyldisilazane, siloxane oligomers such as α,ω-silanol group-capped dimethylsiloxane oligomer, α,ω-silanol group-capped methylphenylsiloxane oligomer, and α,ω-silanol group-capped methylvinylsiloxane oligomer, and the like.

In particular, when a hydrosilylation reaction is selected in either the reaction of primarily curing the curable silicone composition into a gel form or the reaction of secondarily curing the silicone gel layer, it is preferable to blend a hydrosilylation reaction inhibitor as a curing retardant. Examples of the curing retardant include: alkyne alcohols such as 2-methyl-3-butyne-2-ol, 3,5-dimethyl-1-hexyne-3-ol, 2-phenyl-3-butyne-2-ol, 1-ethynyl-1-cychlohexanol; enyne compounds such as 3-methyl-3-pentene-1-yne, 3,5-dimethyl-3-hexene-1-yne; alkenyl group-containing low molecular weight siloxanes such as tetramethyltetravinylcyclotetrasiloxane and tetramethyltetrahexenylcyclotetrasiloxane; and alkynyloxysilanes such as methyl tris(1,1-dimethyl propynyloxy)silane and vinyl tris(1,1-dimethyl propynyloxy)silane. The content of the curing retardant is not limited, but is preferably within the range of 10 to 10000 ppm in terms of mass units, with regard to the curable silicone composition.

As the adhesion imparting agent, an organosilicon compound having at least one alkoxy group bonded to a silicon atom in one molecule is preferable. Examples of this alkoxy group include a methoxy group, an ethoxy group, a propoxy group, a butoxy group, and a methoxyethoxy group, with a methoxy group particularly preferable. Moreover, examples of groups other than alkoxy group, bonded to the silicon atom of the organosilicon compound include: halogen substituted or unsubstituted monovalent hydrocarbon groups such as an alkyl group, an alkenyl group, an aryl group, an aralkyl group, and a halogenated alkyl group; glycidoxyalkyl groups such as a 3-glycidoxypropyl group and a 4-glycidoxybutyl group; epoxycyclohexylalkyl groups such as a 2-(3,4-epoxycyclohexyl)ethyl group and a 3-(3,4-epoxycyclohexyl)propyl group; epoxyalkyl groups such as a 3,4-epoxybutyl group and a 7,8-epoxyoctyl group; acryl group-containing monovalent organic groups such as a 3-methacryloxypropyl group; and hydrogen atoms. This organosilicon compound preferably has a group that may react with an alkenyl group or a silicon atom-bonded hydrogen atom in this composition, and specifically, preferably has a silicon atom-bonded hydrogen atom or an alkenyl group. Moreover, because favorable adhesion can be imparted to various substrates, this organosilicon compound preferably has at least one epoxy group-containing monovalent organic group in one molecule. Examples of such an organosilicon compound include an organosilane compound, an organosiloxane oligomer, and an alkyl silicate. Examples of the molecular structure of this organosiloxane oligomer or alkyl silicate include a linear structure, a partially branched linear structure, a branched structure, a cyclic structure, and a network structure, with a linear structure, a branched structure, and a network structure particularly preferable. Examples of an organosilicon compound include: silane compounds such as 3-glycidoxypropyltrimethoxysilane, 2-(3,4-epoxycyclohexyl)ethyltrimethoxysilane, and 3-methacryloxypropyltrimethoxysilane; siloxane compounds having at least one silicon atom-bonded alkenyl group or at least one silicon atom-bonded hydrogen atom and at least one silicon atom-bonded alkoxy group; mixtures of silane compounds or siloxane compounds having at least one silicon atom-bonded alkoxy group and siloxane compounds having at least one silicon atom-bonded hydroxy group and at least one silicon atom-bonded alkenyl group in one molecule; methylpolysilicate; ethylpolysilicate; and an epoxy group-containing ethylpolysilicate. The adhesion imparting agent is preferably in the form of a low viscosity liquid, and its viscosity is not limited, but it is preferably within the range of 1 to 500 mPa·s at 25°C. In addition, while not limited thereto, the content of this adhesion imparting agent is preferably within the range of 0.01 to 10 parts by mass with regard to 100 parts by mass of the total of the curable silicone composition.

Particularly preferably, the laminate of the present invention has an alkenyl group or a photopolymerizable functional group as a curing reactive group in either the primarily curing reaction of the curable silicone composition or the secondarily curing reaction of the silicone gel layer, and includes an organohydrogenpolysiloxane as a crosslinking agent, and these are preferably cured by a hydrosilylation reaction catalyst. That is, the silicone gel layer according to the present invention is preferably obtained by curing a curable silicone composition composed of a linear organopolysiloxane having at least two alkenyl groups or photopolymerizable functional groups in one molecule as component (A-1), a resinous or branched chain organopolysiloxane having at least two alkenyl groups or photopolymerizable functional groups in one molecule as component (A-2), an organohydrogenpolysiloxane having at least two silicon atom-bonded hydrogen atoms in one molecule as component (B), and a curing reaction catalyst containing a hydrosilylation reaction catalyst as component (C) into a gel form. Note that component (C) may further contain an organic peroxide, and even if the above-mentioned curing reactive functional group is consumed at the time of gel formation in the primarily curing reaction, the secondarily curing reaction proceeds by heating.

Here, the content of each component in the composition is an amount by which the curable silicone composition is capable of being primarily cured in a gel form and the silicone gel layer after the primarily curing reaction is capable of being secondarily-cured. In the case where the primarily curing reaction is a hydrosilylation curing reaction, when the total of alkenyl groups in component (A) in the composition is 1 mol, the amount of the silicon atom-bonded hydrogen atoms in component (B) is preferably 0.25 mol or more, more preferably 0.26 mol or more.

In this case, suitable examples of component (A-1) include dimethylsiloxane/methylvinylailoxane copolymer capped at both molecular chain terminals with trimethylsiloxy groups, dimethylsiloxane/methylvinylailoxane/methylphenylsiloxane copolymer capped at both molecular chain terminals with trimethylsiloxy groups, dimethylpolysiloxane capped at both molecular chain terminals with dimethylvinylsiloxy groups, methylphenylpolysiloxane capped at both molecular chain terminals with dimethylvinylsiloxy groups, dimethylsiloxane/methylvinylsiloxane copolymer capped at both molecular chain terminals with dimethylvinylsiloxy groups, dimethylsiloxane/methylvinylsiloxane copolymer capped at both molecular chain terminals with dimethylphenylsiloxy groups, and dimethylpolysiloxane capped at both molecular chain terminals with methylvinylphenylsiloxy groups.

Similarly, suitable component (A-2) is a resinous organopolysiloxane having a radical reactive group when heated in the presence of a hydrosilylation reactive group and/or high energy ray irradiation or an organic peroxide, and examples of such component (A-2) include MQ resins, MDQ resins, MTQ resins, MDTQ resins, TD resins, TQ resins, and TDQ resins comprised of an arbitrary combination of triorganosiloxy units (M-units) (organo groups are methyl groups only, methyl groups and vinyl groups or phenyl groups), diorganosiloxy units (D-units) (organo groups are methyl groups only, methyl groups and vinyl groups or phenyl groups), monoorganosiloxy units (T-units) (organo groups are methyl groups, vinyl groups, or phenyl groups), and siloxy units (Q-units).

Similary, examples of suitable component (B) include methylphenylpolysiloxane capped at both molecular chain terminals with dimethylhydrogensiloxy groups, dimethylsiloxane/methylphenylsiloxane copolymer capped at both molecular chain terminals with dimethylhydrogensiloxy groups, diphenylpolysiloxane capped at both molecular chain terminals with dimethylhydrogensiloxy groups, methylhydrogenpolysiloxane capped at both molecular chain terminals with trimethylsiloxy groups, methylhydrogensiloxane/dimethylsiloxane copolymer capped at both molecular chain terminals with trimethylsiloxy groups, methylhydrogensiloxane/dimethylsiloxane copolymer capped at both molecular chain terminals with dimethylhydrogensiloxy groups, and a mixture of two or more of these organopolysiloxanes. In the present invention, component (B) is exemplified by methylhydrogensiloxane/dimethylsiloxane copolymer capped at both molecular chain terminals with trimethylsiloxy groups, which has a viscosity of 1 to 500 mPa·s at 25°C. Component (B) may contain a resinous organohydrogenpolysiloxane resin.

Similarly, suitable component (C) contains the hydrosilylation reaction catalyst described above and preferably contains one or more curing agents selected from organic peroxides and photopolymerization initiators, depending on the choice of primarily curing reaction or secondarily curing reaction.

As a coating method for forming a curing reactive silicone gel layer on a substrate, a roll coat using a gravure coat, an offset coat, an offset gravure, an offset transfer roll coater, or the like, a reverse roll coat, an air knife coat, a curtain coat using a curtain flow coater, or the like, a comma coat, a meyer bar, or any other known method used for forming a cured layer can be used without limitation.

### Preferred Combination of Primarily Curing Reaction Mechanism and Secondarily Curing Reaction Mechanism

In the silicone gel layer according to the present invention, it is preferable that the curable silicone composition is cured into a gel form by a curing mechanism of a hydrosilylation reaction curing type, a dehydration condensation reaction curing type, a dealcoholization condensation reaction curing type, or a radical reaction curing type by high energy ray irradiation. In particular, a hydrosilylation reaction curing type at a low temperature of 100°C. or lower, a radical reaction curing type by high energy ray irradiation at room temperature, or a hydrosilylation reaction curing type by high energy ray irradiation is suitable.

The secondarily curing reaction of the silicone gel layer is preferably a curing reaction that proceeds at elevated temperatures above 100 degrees Celsius and is preferably a hydrosilylation reaction curing type or a peroxide curing reaction type. As described above, it is preferable to control the reaction so that the reaction is secondarily cured at a temperature higher than the melting temperature of the thermoplastic resin, which is the encapsulation wall material, by using the encapsulated hydrosilylation reaction catalyst.

### Manufacturing Method of Electronic Components

As described above, the laminate of the present invention is useful for the manufacture of electronic components, and by forming a silicone gel layer on a substrate to form an arrangement surface of the electronic component which is stable, flat, and excellent in stress relaxation property, it is possible to realize the advantage that the processing failure of the electronic component due to the surface unevenness of the substrate, positional deviation of the electronic component, and vibration displacement (damping) at the time of manufacture of the electronic component is unlikely to occur. Further, by curing the silicone gel layer, the electronic component can be easily peeled off from the cured product, and a defective product derived from a residue such as silicone gel (adhesive deposit) is hardly generated.

Specifically, the method of manufacturing an electronic component of the present invention includes (I) a step of arranging at least one or more electronic components on the silicone gel layer of the laminate of the present invention, (II) a step of curing a part or whole of the silicone gel layer, and optionally (III) a step of separating the electronic component from the cured product obtained by curing a part or whole of the silicone gel layer by the above step.

The electronic component is as described in the section [Laminate Including Electronic Components], and in the method for manufacturing an electronic component of the present invention, a step of forming an electronic circuit, an electrode pattern, an insulating film, and the like on the electronic component after being arranged on the silicone gel layer may be included, and it is preferable. Optionally, the laminate may be diced.

The step (II) of curing a part or whole of the silicone gel layer is a step of secondarily curing of a curable silicone gel layer, and the silicone gel layer is changed into a hard cured layer having higher shape retention and superior mold releasability than before the curing reaction. As a result, in the subsequent step (III), the electronic component arranged on the silicone gel layer is easily separated, and problems such as deposits of the silicone gel or a cured product thereof to the substrate or the electronic component are hardly caused.

### Examples

Hereinafter, the present invention will be described by way of examples, but the present invention is not limited thereto. In the examples shown below, the following compounds or compositions were used as raw materials.
- Component (A1-1): dimethylsiloxane polymer capped at both terminals with vinyldimethylsiloxy groups (polymerization degree of siloxane: about 540, vinyl group content: 0.13 weight%)
- Component (A1-2): dimethylsiloxane polymer capped at both terminals with vinyldimethylsiloxy groups (polymerization degree of siloxane: about 315, vinyl group content: 0.22 weight%)
- Component (A1-3): dimethylsiloxane/vinylmethylsiloxane copolymer capped at both terminals with trimethylsiloxy groups (polymerization degree of siloxane: about 1330, vinyl group content: about 0.47 weight%)
- Component (A2): resinous organopolysiloxane composed of trimethylsiloxy units (M units), vinyldimethylsiloxy units (M^{Vi} units), and Q units (vinyl group content: about 4.1 weight%)
- Component (B1): dimethylsiloxane polymer capped at both terminals with hydrogendimethylsiloxy groups (polymerization degree of siloxane: about 14, silicon bonded hydrogen group content: 0.13 weight%)
- Component (B2): dimethylsiloxane/mercaptopropylmethylsiloxane copolymer capped at both terminals with trimethylsiloxy groups (polymerization degree of siloxane: about 60, sulfur bonded hydrogen group content: 0.11 weight%)
- Component (B3): dimethylsiloxane/hydrogenmethylsiloxane copolymer capped at both terminals with trimethylsiloxy groups (polymerization degree of siloxane: about 8, silicon bonded hydrogen group content: 0.76 weight%)

### Hydrosilylation Reaction Inhibitor

- Component (C1): 1,3,5,7-tetramethyl-1,3,5,7-tetravinyl-cyclotetrasiloxane (vinyl group content: 30.2 weight%)

### Filler

- Component (D1): hexamethyldisilazane-treated silica fine particle (Trade name "Aerosil 200V", manufactured by Nippon Aerosil)

### Curing agent

- Component (E1): solution of platinum-divinyltetramethyldisiloxane complex in vinylsiloxane (about 0.6 weight% of platinum metal concentration)
- Component (E2): 2-hydroxy-2-methyl-1-phenyl-propane-1-one
- Component (E3): mixture of 2,5-dimethyl-2,5-di(tert-butylperoxy)hexane and siloxane polymer capped at both terminals with trimethylsiloxy groups (about 50 weight% in concentration of 2,5-dimethyl-2,5-di(tert-butylperoxy)hexane)

### Dealcoholization Condensation Type Curing Reactive Silicone Composition

### SE9120 (manufactured by Dow Toray Co., Ltd.)

* Condensation curable silicone composition based on an organopolysiloxane containing an alkoxysilyl group and containing a condensation reaction catalyst

### Compositions: Examples 1 to 7

In Examples 1 to 7 below, components (A1-1), (A1-2), (A2), (B1), (C1), (D1), (E1) and (E3) were used as described in Table 1. In this case, the amount of silicon atom-bonded hydrogen atoms (Si-H) of component (B1) was 0.25 to 0.50 mol per 1 mol of the vinyl group.

### Compositions: Examples 8 and 9

In Examples 8 and 9, components (A1-2), (A1-3), (B1), (D1), (E2) and (E3) were used as described in Table 2. In this case, the amount of sulfur atom-bonded hydrogen atoms (S-H) of component (B2) was 0.25 mol per 1 mol of the vinyl group.

### Compositions: Examples 10 to 12

In Examples 10 to 12, (A1-2), (A1-3), (B3), (C1), (D1), and (E1) were used as described in Table 3. In this case, the amount of silicon atom-bonded hydrogen atoms (Si-H) of component (B3) was 1.2 mol per 1 mol of the vinyl group. The resulting liquid silicone composition before curing was mixed with a dealcoholization condensation type curing reactive curable silicone composition (moisture cured) SE9120 (manufactured by Dow Toray Co., Ltd.) in the weight ratios (40:60, 30:70 or 20:80) listed in the table and used.

### Compositions: Comparative Examples 1 to 4

In Comparative Examples 1 to 4, as described in Table 4, the same components as in Examples 1 to 7 were used except that the silicon atom-bonded hydrogen atoms (Si-H) of component (B1) were used in amounts ranging from 0.2 to 0.25 mols per 1 mol of the vinyl group in the compositions. In the compositions, as shown in Table 4, even if cured under the same conditions, it does not cure into a gel form, and a silicone gel layer having curing reactivity cannot be formed.

### Compositions: Comparative Examples 5, 6, and 7

As described in Table 4, the same components as in Examples 8 and 9 were used except that only component (E2) was used as the curing agent in Comparative Example 5 and only component (E3) was used in Comparative Example 6. In Comparative Example 7, the same components as in Examples 1 to 7 were used except that only component (E1) was used as the curing agent. In these compositions, as shown in Table 4, the silicone gel layer does not have secondarily curability even when cured under the same conditions.

### Conditions for Preparation of Curable Gel Layer

### (1) Examples 1 to 7, Comparative Examples 1 to 4 and 7

The silicone composition before curing (liquid) was heated at 80°C. for 2 hours to proceed the hydrosilylation reaction to obtain a gel form.

### (2) Examples 8 and 9 and Comparative Examples 5 and 6

The liquid composition before curing was carried out at room temperature using a UV-irradiation device (MODEL UAW365-654-3030F, Centech, Inc.). In this case, a light source having a wavelength of 365 nm (about 40 mW/cm²) was used and irradiated twice for 90 seconds (the irradiation amount per unit area was 7200 mJ/cm²). At this time, in order to avoid contact between the high energy ray curable silicone composition and air, a PET film coated with a release agent and having a thickness of 50 microns was covered and irradiated with ultraviolet light. In Comparative Example 6, since there was no component (E2), a gel layer could not be prepared.

### (3) Examples 10 to 12

The liquid composition before curing was left at room temperature for 1 hour to obtain a gel form.

### Conditions for Manufacturing Secondarily Cured Products

### (1) Examples 1 to 9 and Comparative Examples 1 to 4 and 7

The curable gel layer was secondarily cured in nitrogen at 170°C. for 1 hour.

### (2) Examples 10 to 12

The curable gel layer was secondarily cured at 150°C. for 30 minutes.

### Method for Measuring the Physical Properties of the Obtained Material

### 1. Measurement of Compressive Deformation Amount of Curing Reactive Silicone Gel

15 g of the liquid composition before curing of each of Examples 1 to 7 was put into a glass petri dish (diameter: 70 mm) and the composition prepared under the above conditions was used. Measurements were performed at room temperature using a texture analyzer TA. XT Plus (manufactured by EKO Instruments). The flat probe (diameter: 6 mm) was lowered at a rate of 0.17 mm per second to determine the amount of compressive deformation of the curable gel after reaching a maximum compressive force of 0.5 N.

### 2. Tack measurement

### Curing Reactive Silicone Gel

(1) In Examples 1 to 7, after measuring the amount of compressive deformation, the flat probe was raised to a height equal to or greater than the initial thickness of the curable gel at a rate of 0.34 mm per second, and the maximum value of the load was measured as tack. Since the measured values are obtained as negative values, the absolute values are shown in the table. The higher this value, the more tack is present.
(2) In Examples 10 to 12, the liquid silicone composition before curing was applied to a thickness of 360 µm on a glass plate using a spacer, and the composition prepared under the above conditions was used. The presence or absence of tack was judged by touching with a hand.

### Secondarily Cured Product

In Examples 10 to 12, the curable gel prepared was cured under the above conditions to obtain a secondarily cured product. The secondarily cured product thus obtained was touched by hand to determine the presence or absence of tack.

### 3. Measurement of Viscoelasticity

### Curing Reactive Silicone Gel

The liquid silicone composition before curing was put into an aluminum container having a diameter of 50 mm so as to have a thickness of about 1.5 mm, and a test specimen was cut out from the curing reactive silicone gel obtained under the above conditions so as to have a diameter of 8 mm and used. Using a MCR302 viscoelasticity measuring device (manufactured by Anton Paar Corporation), samples cut out on parallel plates having diameters of 8 mm were attached and measured. Measurement was carried out at 23°C. at a frequency in the range of 0.01 to 10 Hz and under a strain of 0.5%. Each table shows the storage modulus and loss tangent (loss elastic modulus/storage modulus) at 0.1 Hz.

### Secondarily Cured Product

In the same manner as described above, a curing reactive silicone gel was produced using an aluminum container. A secondarily cured product was obtained by further curing under the above manufacturing conditions. Test specimens were cut out from the obtained secondarily cured products so as to have a diameter of 8 mm and used. Using MCR302 (manufactured by Anton Paar Corporation), samples cut out on parallel plates having diameters of 8 mm were attached and measured. Measurement was carried out at 23°C. at a frequency in the range of 0.01 to 10 Hz and under a strain of 0.1%. Each table shows the storage modulus at 0.1 Hz.

**Table 1**

| Example No. | 1 | 2 | 3 | 4 | 5 | 6 | 7 |
|---|---|---|---|---|---|---|---|
| Component (A1-1) | 31.38 | 45.98 | 47.03 | 44.87 | 43.92 | 30.13 | 29.21 |
| Component (A1-2) | 34.59 | 5.96 | 6.07 | 6.09 | 5.98 | 33.24 | 32.26 |
| Component (A1-3) | | | | | | | |
| Component (A2) | 21.27 | 31.17 | 31.88 | 30.42 | 29.77 | 20.42 | 19.80 |
| Component (B1) | 8.51 | 12.63 | 10.75 | 14.36 | 16.08 | 11.95 | 14.47 |
| Component (B2) | | | | | | | |
| Component (B3) | | | | | | | |
| Component (C1) | 0.10 | 0.10 | 0.10 | 0.10 | 0.10 | 0.10 | 0.10 |
| Component (D1) | 2.08 | 2.08 | 2.08 | 2.08 | 2.08 | 2.08 | 2.08 |
| Component (E1) | 0.07 | 0.07 | 0.07 | 0.07 | 0.07 | 0.07 | 0.07 |
| Component (E2) | | | | | | | |
| Component (E3) | 2.00 | 2.00 | 2.00 | 2.00 | 2.00 | 2.00 | 2.00 |
| SiH/Vi ratio | 0.27 | 0.30 | 0.25 | 0.35 | 0.40 | 0.40 | 0.50 |
| Compression ratio/% | 50.08 | 17.44 | 25.32 | 7.46 | 3.47 | 14.42 | 3.57 |
| Tack/N* | 0.056 | 0.19 | 0.16 | 0.34 | 0.39 | 0.22 | 0.38 |
| Reactive gel storage modulus (x 10³ Pa) | 0.4 | 7.4 | 4.4 | 10.0 | 21.8 | 6.6 | 19.3 |
| Reactive gel loss tangent | 0.82 | 0.43 | 0.64 | 0.27 | 0.18 | 0.16 | 0.10 |
| Storage modulus after secondarily curing (x 10⁵ Pa) | 0.3 | 1.7 | 1.1 | 2.6 | 1.5 | 0.7 | 0.8 |

| | | | | | | | |
|---|---|---|---|---|---|---|---|
| *Since it is a negative value, it is represented by an absolute value. | | | | | | | |

**Table 2**

| Example No. | 8 | 9 |
|---|---|---|
| Component (A1-1) | | |
| Component (A1-2) | 65.52 | 70.28 |
| Component (A1-3) | 27.80 | 23.13 |
| Component (A2) | | |
| Component (B1) | | |
| Component (B2) | 2.41 | 2.30 |
| Component (B3) | | |
| Component (C1) | | |
| Component (D1) | 2.08 | 2.08 |
| Component (E1) | | |
| Component (E2) | 0.20 | 0.20 |
| Component (E3) | 2.00 | 2.00 |
| SH/Vi ratio | 0.25 | 0.25 |
| Reactive gel storage modulus (x 10³ Pa) | 8.2 | 8.4 |
| Reactive gel loss tangent | 0.03 | 0.04 |
| Storage modulus after secondarily curing (x 10⁵ Pa) | 0.4 | 0.8 |

**Table 3**

| Example No. | 10 | 11 | 12 |
|---|---|---|---|
| Component (A1-1) | | | |
| Component (A1-2) | 6.05 | 6.05 | 6.05 |
| Component (A1-3) | 88.90 | 88.90 | 88.90 |
| Component (A2) | | | |
| Component (B1) | | | |
| Component (B2) | | | |
| Component (B3) | 2.75 | 2.75 | 2.75 |
| Component (C1) | 0.11 | 0.11 | 0.11 |
| Component (D1) | 2.12 | 2.12 | 2.12 |
| Component (E1) | 0.07 | 0.07 | 0.07 |
| Component (E2) | | | |
| Component (E3) | | | |
| SH/Vi ratio | 1.2 | 1.2 | 1.2 |
| SE9120** | 60%** | 70%** | 80%** |
| Tack of reactive gel | Yes | Yes | Yes |
| Tack of secondarily cured product | No | No | No |

| | | | |
|---|---|---|---|
| ** Percentage in mixture (as 100 weight%) with the liquid silicone composition before curing made using Components A to E. | | | |

**Table 4**

| Comparative Example No. | 1 | 2 | 3 | 4 | 5 | 6 | 7 |
|---|---|---|---|---|---|---|---|
| Component (A1-1) | 31.89 | 26.25 | 37.59 | 26.63 | | | 47.99 |
| Component (A1-2) | 35.14 | 44.90 | 25.51 | 45.54 | 71.70 | 70.39 | 6.20 |
| Component (A1-3) | | | | | 23.62 | 23.19 | |
| Component (A2) | 21.62 | 17.79 | 25.48 | 18.05 | | | 32.53 |
| Component (B1) | 7.10 | 6.80 | 7.16 | 5.52 | | | 10.97 |
| Component (B2) | | | | | 2.36 | 2.32 | |
| Component (B3) | | | | | | | |
| Component (C1) | 0.10 | 0.10 | 0.10 | 0.10 | | | 0.11 |
| Component (D1) | 2.08 | 2.08 | 2.08 | 2.08 | 2.12 | 2.09 | 2.12 |
| Component (E1) | 0.07 | 0.07 | 0.07 | 0.07 | | | 0.07 |
| Component (E2) | | | | | 0.20 | | |
| Component (E3) | 2.00 | 2.00 | 2.00 | 2.00 | | 2.00 | |
| SiH/Vi ratio | 0.23 | 0.25 | 0.20 | 0.20 | | | 0.25 |
| SH/Vi ratio | | | | | 0.25 | 0.25 | |
| Reactive gel storage modulus (x 10³ Pa) | - | - | - | - | Not measured. | Not measured. * | 4.0 |
| Reactive gel loss tangent | | | | | Not measured. | Not measured. | 0.69 |
| Curability | Reactive gel layer could not be obtained. | | | | No secondarily curability | | |

| | | | | | | | |
|---|---|---|---|---|---|---|---|
| * Gel layer could not be formed. | | | | | | | |

## Claims

1. A laminate comprising a curing reactive silicone gel layer on at least one type of substrate.

2. The laminate according to claim 1, wherein a storage modulus (G'_{cured}) of a cured product of the silicone gel layer obtained by a curing reaction is at least 100% larger than a storage modulus (G'_{gel}) of the silicone gel layer before curing.

3. The laminate according to claim 1 or claim 2, wherein a loss factor, tan δ of the silicone gel layer is in the range of 0.01 to 1.00 at 23°C. to 100°C.

4. The laminate according to any one of claims 1 to 3, wherein the silicone gel layer is curing reactive to heating, irradiation with high energy rays, or a combination thereof.

5. The laminate according to any one of claims 1 to 4, wherein the silicone gel layer contains one or more curing agents selected from a hydrosilylation reaction catalyst, an organic peroxide, and a photopolymerization initiator.

6. The laminate according to any one of claims 1 to 5, wherein the silicone gel layer is obtained by curing a curable silicone composition containing at least a resinous or branched chain curing reactive organopolysiloxane into a gel form.

7. The laminate according to claim 6, wherein the silicone gel layer is obtained by curing the curable silicone composition in a gel form in a temperature range of room temperature to 100°C.

8. The laminate according to any one of claims 1 to 7, wherein an average thickness of the silicone gel layer is in the range of 10 to 500 µm.

9. The laminate according to claim 1, wherein the substrate is a release layer-provided sheet-shaped substrate (substrate R), and the silicone gel layer is formed on the release layer.

10. The laminate according to any one of claims 1 to 8, wherein at least one or more electronic components are arranged on the silicone gel layer.

11. A laminate obtained by curing the silicone gel layer on the laminate of claim 10 to thereby provide a structure of a substrate, a cured layer, and at least one or more electronic components arranged on the cured layer.

12. A method of manufacturing the laminate according to any one of claims 1 to 8, comprising:
(A-1) a step of applying a curable silicone composition capable of forming a silicone gel layer by a primarily curing reaction on at least one type of substrate, and
(A-2) a step of forming a curing reactive silicone gel layer by primarily curing the curable silicone composition on the substrate in a gel form.

13. A method of manufacturing the laminate according to any one of claims 1 to 8, comprising:
(B-1) a step of applying a curable silicone composition capable of forming a silicone gel layer by a primarily curing reaction on a release layer of a release layer-provided sheet-shaped substrate (substrate R),
(B-2) a step of forming a curing reactive silicone gel layer by primarily curing the curable silicone composition on the release layer in a gel form, and
a step of arranging the silicone gel layer of the laminate obtained in step (B-2) on at least one type of substrate different from the substrate R, and removing only the substrate R.

14. A method of manufacturing an electronic component, comprising:
(I) a step of arranging at least one or more electronic components on the silicone gel layer of the laminate according to any one of claims 1 to 8, and
(II) a step of curing a part or whole of the silicone gel layer.

15. The method of manufacturing an electronic component according to claim 14, further comprising (III) a step of separating the electronic components from a cured product obtained by curing a part or whole of the silicone gel layer by step (II).
